(19) Europäisches Patentamt / European Patent Office / Office européen des brevets

(11) **EP 4 679 213 A1**

(12) **EUROPEAN PATENT APPLICATION**

(43) Date of publication:
**14.01.2026 Bulletin 2026/03**

(21) Application number: **25187064.8**

(22) Date of filing: **02.07.2025**

(51) International Patent Classification (IPC):
*G05B 23/02* (2006.01)

(52) Cooperative Patent Classification (CPC):
**G05B 23/0281;** G05B 2219/25255

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **08.07.2024 KR 20240089958**

(71) Applicant: SAMSUNG SDI CO., LTD.
**Yongin-si, Gyeonggi-do 17084 (KR)**

(72) Inventors:
• **KANG, Changseong**
**17084 Yongin-si (KR)**
• **KIM, Hakkyu**
**17084 Yongin-si (KR)**
• **NOH, Minjong**
**17084 Yongin-si (KR)**
• **KIM, Joonseek**
**17084 Yongin-si (KR)**

(74) Representative: **Marks & Clerk LLP**
**15 Fetter Lane**
**London EC4A 1BW (GB)**

(54) **METHOD AND SYSTEM FOR DETECTING ABNORMAL POINT OF BATTERY MANUFACTURING DATA AND ANALYZING ITS CAUSE**

(57) The present disclosure relates to a method and system for detecting an abnormal point of battery manufacturing data and analyzing its cause. The method is performed by the system for detecting the abnormal point of the battery manufacturing data and analyzing its cause, and includes collecting training data including material information, design information, process information, and information on whether an abnormal point has occurred, of a battery to be analyzed, selecting latent factors that cause the abnormal point from among material elements, design elements, and process elements on the basis of the training data, forming an artificial neural network structure on the basis of the selected latent factors, training the artificial neural network structure on the basis of the training data, and generating an abnormal point cause analysis model.

FIG. 1

START

COLLECT TRAINING DATA — S110

SELECT LATENT FACTOR — S120

GENERATE ABNORMAL POINT CAUSE ANALYSIS MODEL — S130

COLLECT AND MONITOR MANUFACTURING DATA — S140

HAS ABNORMAL POINT OCCURRED? — S150 — NO

YES

SELECT KEY FACTORS — S160

END

EP 4 679 213 A1

## Description

### FIELD

Aspects of some embodiments of the present disclosure relate to a method and system for detecting an abnormal point of battery manufacturing data and analyzing its cause.

### BACKGROUND

A battery design and simulation management system is a basic system for developing batteries to be applied to new models, and is a system that integrates and manages information generated throughout an entire battery development process (material, design, process, and evaluation), centered on design information. That is, the battery design and the simulation system is a system that integrates and manages material information, process information, and evaluation information that are related to design information, centered on the design information, into a database, and the system utilizes the integrated information for design optimization, simulation, etc.

The herein information disclosed in this Background section is for enhancement of understanding of the background of the present disclosure, and therefore, it may contain information that does not constitute a related (or prior) art.

### SUMMARY

The present disclosure is directed to providing a method and system for detecting an abnormal point of battery manufacturing data and analyzing its cause, which are capable of linking collected material information, design information and process information, and when abnormal point data occurs in a process, selecting key factors affecting occurrence of the abnormal point from among the entire material-design-process area using a machine-learning-based abnormal point cause analysis model that has been previously trained.

Objects of the present disclosure are not limited to the herein-described object and other objects of the present disclosure that are not described may be clearly understood by those skilled in the art from the following descriptions.

A method of detecting an abnormal point of battery manufacturing data and analyzing its cause according to the present disclosure is performed by a system for detecting an abnormal point of battery manufacturing data and analyzing its cause (e.g., an abnormal point detection and cause analysis system), and includes collecting training data including material information, design information, process information, and information on whether an abnormal point has occurred, of a battery to be analyzed, selecting latent factors that cause the abnormal point from among material elements, design elements, and process elements on the basis of the training data, forming an artificial neural network structure on the basis of the selected latent factors, training the artificial neural network structure on the basis of the training data, and generating an abnormal point cause analysis model.

According to some embodiments, there is provided a method of detecting an abnormal point of battery manufacturing data and analyzing its cause, the method comprising: collecting, by an abnormal point detection and cause analysis system for detecting the abnormal point of battery manufacturing data and analyzing its cause, training data including material information, design information, process information, and information on whether an abnormal point has occurred, of a battery to be analyzed; selecting, by the abnormal point detection and cause analysis system, latent factors that cause the abnormal point from among material elements, design elements, and process elements on the basis of the training data; and forming, by the abnormal point detection and cause analysis system, an artificial neural network structure on the basis of the selected latent factors; training the artificial neural network structure on the basis of the training data; and generating an abnormal point cause analysis model.

In some embodiments, the selecting of the latent factors comprises: selecting, by a user of the abnormal point detection and cause analysis system, fixed factors from among the material elements, the design elements, and the process elements; selecting, by the abnormal point detection and cause analysis system, variable factors from among remaining elements excluding the fixed factors from among the material elements, the design elements, and the process elements using the training data; and selecting, by the abnormal point detection and cause analysis system, the fixed factors and the variable factors as the latent factors.

In some embodiments, the selecting of the variable factors comprises: repeating, by the abnormal point detection and cause analysis system, a process for randomly sampling a predetermined number of items from among the material elements, the design elements, and the process elements and generating a plurality of decision trees for the sampled items a predetermined number of times; selecting some decision trees from among the plurality of generated decision trees on the basis of an average Gini index of the plurality of decision trees; and selecting the variable factors on the basis of the some decision trees.

In some embodiments, the selecting of the variable factors comprises selecting the variable factors on the basis of a frequency of appearance in the some decision trees. In some embodiments, the method further comprises collecting, by the abnormal point detection and cause analysis system, manufacturing process data of the battery to be analyzed and determining whether the abnormal point has occurred in the manufacturing process data using a statistical technique; and when it is determined that the abnormal point has occurred in the manufacturing process data, selecting, by the abnormal point detection and cause analysis system, key factors affecting occurrence of the abnormal point from among the selected latent factors using the abnormal point cause analysis model on the basis of the material information, the design information, and the process information of the battery to be analyzed.

In some embodiments, the statistical technique comprises kernel density estimation.

According to some embodiments, there is provided an abnormal point detection and cause analysis system for detecting an abnormal point of battery manufacturing data and analyzing its cause, comprising: a non-transitory memory configured to store computer-readable instructions; and at least one processor configured to execute the computer-readable instructions, wherein the at least one processor is configured to, by executing the computer-readable instructions, perform a method comprising: collecting training data including material information, design information, process information, and information on whether an abnormal point has occurred, of a battery to be analyzed, selecting latent factors that cause the abnormal point from among material elements, design elements, and process elements on the basis of the training data, and forming an artificial neural network structure on the basis of the selected latent factors; training the artificial neural network structure on the basis of the training data; and generating an abnormal point cause analysis model.

In some embodiments, the selecting the latent factors comprises selecting variable factors from among remaining elements excluding fixed factors from among the material elements, the design elements, and the process elements using the training data and selecting the fixed factors and the variable factors as the latent factors when a user of the abnormal point detection and cause analysis system selects the fixed factors from among the material elements, the design elements, and the process elements.

In some embodiments, the method further comprises, in the process for selecting the variable factors: repeating, by the abnormal point detection and cause analysis system, a process for randomly sampling a predetermined number of items from among the material elements, the design elements, and the process elements and generating a plurality of decision trees for the sampled items a predetermined number of times; selecting some decision trees from among the plurality of generated decision trees on the basis of an average Gini index of the plurality of decision trees; and selecting the variable factors on the basis of the some decision trees.

In some embodiments, the method further comprises, in the process for selecting the variable factors, selecting the variable factors on the basis of a frequency of appearance in the some decision trees.

In some embodiments, the method further comprises: collecting manufacturing process data of the battery to be analyzed and determine whether the abnormal point has occurred in the manufacturing process data using a statistical technique; and selecting key factors affecting occurrence of the abnormal point from among the selected latent factors using the abnormal point cause analysis model on the basis of the material information, the design information, and the process information of the battery to be analyzed when it is determined that the abnormal point has occurred in the manufacturing process data.

In some embodiments, the statistical technique comprises kernel density estimation. A latent factor may be a parameter that is determined to be associated with abnormal points (e.g. a parameter in which abnormalities are frequently found).

In some embodiments, the abnormal point cause analysis model is used to identify an abnormal point based on battery manufacturing data. Values for each latent factor taken from the battery manufacturing data may be input into the abnormal point cause analysis model to determine whether the values represent an abnormal point (e.g. indicate an abnormality in the battery manufacturing data).

In some embodiments, the abnormal point cause analysis model is used to identify a cause of an abnormal point based on battery manufacturing data. For instance, an abnormal point may be detected based on one or more parameters falling outside of one or more corresponding predefined ranges (e.g. specifications). In response to the identification of an abnormal point, values for each latent factor taken from the battery manufacturing data may be input into the abnormal point cause analysis model to output a prediction of whether the values represent an abnormal point (e.g. indicate an abnormality in the battery manufacturing data). Based on this output, and based on the knowledge that an abnormal point has occurred (e.g. due to out-of-specification parameter(s)), the weights of the artificial neural network may be updated over one or more training steps (e.g. one or more rounds of backpropagation). The one or more latent factors that are associated with the largest change in weight over the one or more training steps may be determined to be one or more key factors that affect (e.g. contribute or cause) the abnormal point.

The battery manufacturing data may comprise data measured from one or more real-world manufacturing processes. That is, the battery manufacturing data may comprise sensor data measuring one or more parameters during the real-world manufacture of one or more battery cells, modules, or packs. The artificial neural network may be trained on real-world data, simulated data, or on a combination of real-world and simulated data.

At least some of the above and other features of the invention are set out in the claims. Aspects and features of the present disclosure are not limited to those described herein, and other aspects and features not specifically mentioned herein will be clearly understood by those skilled in the art from the description of the present disclosure herein.

## BRIEF DESCRIPTION OF THE DRAWINGS

The following drawings attached to the present specification illustrate embodiments of the present disclosure and further describe aspects and features of the present disclosure together with the detailed description of the present disclosure. Thus, the present disclosure should not be construed as being limited to the drawings, in which:

FIG. 1 is a flowchart for describing a method of detecting an abnormal point of battery manufacturing data and analyzing its cause according to embodiments of the present disclosure;

FIG. 2 is a diagram for describing a process for selecting latent factors that cause an abnormal point using decision trees and a Gini index according to embodiments of the present disclosure;

FIGS. 3A to 3C are classification diagrams of latent factors related to materials, designs, and processes according to embodiments of the present disclosure;

FIG. 4 shows an example of an abnormal point cause analysis model with an artificial neural network structure in which nodes are formed according to a result of selection of latent factors according to embodiments of the present disclosure;

FIGS. 5A and 5B show examples of scatter plots showing time series data for each process item according to embodiments of the present disclosure;

FIGS. 6A and 6B show examples of kernel density estimation plots showing a data distribution of process items according to embodiments of the present disclosure; and

FIG. 7 is a block diagram illustrating a configuration of a system for detecting an abnormal point of battery manufacturing data and analyzing its cause according to embodiments of the present disclosure.

## DETAILED DESCRIPTION

Hereinafter, embodiments of the present disclosure will be described, in detail, with reference to the accompanying drawings. The terms or words used in the present specification and claims are not to be narrowly interpreted according to their general or dictionary meanings and should be interpreted as having meanings and concepts that are consistent with the technical idea of the present disclosure on the basis of the principle that an inventor can be his/her own lexicographer to appropriately define concepts of terms to describe his/her disclosure in the best way.

The embodiments described in this specification and the configurations shown in the drawings are only some embodiments of the present disclosure and do not represent all of the aspects, features, and embodiments of the present disclosure. Accordingly, it should be understood that there may be various equivalents and modifications that can replace or modify one or more embodiments or features therein described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of Article 123(2) EPC.

References to two compared elements, features, etc. as being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average. Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

The terminology used herein is for the purpose of describing embodiments of the present disclosure and is not intended to limit the present disclosure.

In many cases, abnormal data generated in battery manufacturing processes is not well managed in terms of its occurrence history, and when device developers directly access a process system (a manufacturing execution system (MES) or Advanced Quality Management System(AQMS)) in order to analyze causes of the abnormal data, extract the abnormal data and related data, and manually analyze the extracted abnormal data and related data, there is a problem of not only inconvenience, but also waste of time and money.

Further, a systematic method of combining domain knowledge and machine learning techniques for abnormal data generated in battery manufacturing processes to explore its cause throughout materials, designs, and processes has not yet been presented. The present disclosure relates to a method and system for detecting an abnormal point of battery manufacturing data and analyzing its cause, through which an abnormal point that occurs during a development process or production process is detected and causes of the abnormal point are derived through a machine learning technique. First, in the present disclosure, it is assumed that design information, material information, process information, and evaluation information collected during test production or mass production while batteries are developed are linked based on a design identifier (design ID) and integrated and stored in a database of a battery design and simulation management system. For example, the management system may link and store material information, process information, and evaluation information centered on design information.

A system 1000 for detecting an abnormal point of battery manufacturing data and analyzing its cause (hereinafter referred to as an "abnormal point detection and cause analysis system") according to the present disclosure accesses a database to extract training data consisting of design information, material information, and process information that are linked to (e.g. associated with) each other, select latent factors that cause the abnormal point on the basis of the training data, and generate a machine-learning-based abnormal point cause analysis model.

In the present disclosure, abnormal point data is data that is out of specification (spec-out or out-of-specification) from among data collected from a production process of battery cells, modules, or packs, or deviates from a trend. In this context, a "specification" may refer to a predefined set of requirements for the manufacturing process and/or for the manufactured product(s) (e.g. the battery cell(s), module(s), or pack(s)). For instance, a specification may define, for each parameter of a set of parameters, one or more predefined ranges of values that are considered acceptable (e.g. non-abnormal).

In the present disclosure, "spec-out" and the "trend deviation" are defined as in the following 1) and 2):

1) Spec-out: a case in which data that is out of specification for any one of the major process items occurs during a run (continuous data generation) in the process; and

2) Trend deviation: a case in which there is a significant difference in a data generation pattern in a run performed in a current process and a data generation pattern in a past run of the same model (each design may be identified by a design identifier).

The abnormal point detection and cause analysis system 1000 analyzes whether an abnormal point has occurred in the run performed in the process, and when abnormal point data is detected, searches for causes of the abnormal point for the performed run using an abnormal point cause analysis model that has been previously trained.

In this process, the abnormal point detection and cause analysis system 1000 may analyze the influence of latent factors such as material elements, design elements, and process elements related to the corresponding run on the abnormal point using the abnormal point cause analysis model and estimate causes of the abnormal point on the basis of the influence. Further, the abnormal point detection and cause analysis system 1000 may automatically transmit a result of the data analysis to a user (e.g., a model developer who has input the run data). The abnormal point detection and cause analysis system 1000 may utilize one of various methods such as mail, text messages, a file sharing service, a real-time messenger, a social networking service (SNS), and the like as the method of transmitting the result of the data analysis.

According to the embodiments of the present disclosure, by utilizing the material information, design information, and process information that are linked through the battery design and simulation management system, there is an advantage of minimizing the inconvenience of directly extracting and analyzing data from various information sources in searching for the abnormal point and analyzing its cause, and there is an advantage of providing information on key causes that contributed to the occurrence of the abnormal point to the model developer through advanced abnormal point detection and cause analysis by integrating domain knowledge, statistical techniques, and machine learning techniques.

Advantages and features of the present disclosure and methods of achieving the same will be clearly understood with reference to the accompanying drawings and embodiments described in detail herein. However, the present disclosure is not limited to the embodiments to be disclosed herein but may be implemented in various different forms. The embodiments are provided in order to make the present embodiments complete and fully explain the scope of the present disclosure for those skilled in the art. The scope of the present disclosure is defined by the appended claims. Meanwhile, the terms used herein are provided only to describe the embodiments of the present disclosure and not for purposes of limitation. **In** this specification, the singular forms include the plural forms unless the context clearly indicates otherwise. It will be understood that the terms "comprise" and/or "comprising" used herein specify some stated components, steps, operations and/or elements but do not preclude the presence or addition of one or more other components, steps, operations and/or elements.

It should be understood that, although the terms "first," "second," and the like may be used herein to describe various elements, the elements are not limited by these terms. These terms are only used to distinguish one element from another element. For example, a first element could be named a second element, and similarly, a second element could be named a first element, without departing from the scope of the present disclosure.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe relationships between elements should be interpreted in a like fashion (i.e., "between" versus "directly between," "adjacent" versus "directly adjacent," etc.).

In description of the present disclosure, when it is determined that detailed descriptions of related well-known technology may unnecessarily obscure the gist of the present disclosure, detailed descriptions thereof will be omitted

Hereinafter, embodiments of the disclosure will be described in detail with reference to the accompanying drawings. In description of the disclosure, in order to facilitate overall understanding, like reference numerals are used for like elements throughout the drawings.

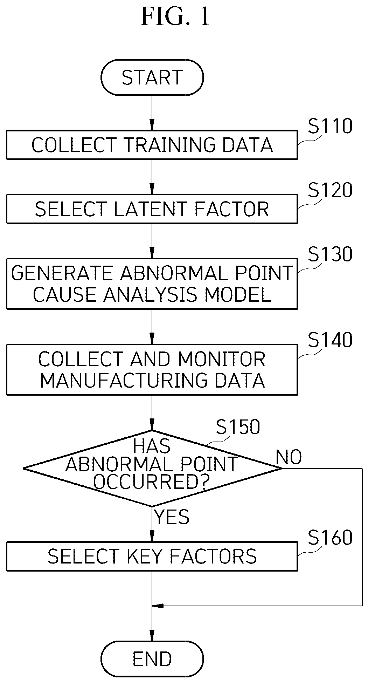

FIG. 1 is a flowchart for describing a method of detecting an abnormal point of battery manufacturing data and analyzing its cause according to embodiments of the present disclosure.

Referring to FIG. 1, the method of detecting the abnormal point of the battery manufacturing data and analyzing its cause according to the embodiments of the present disclosure includes operations S110 to S160. The method of detecting the abnormal point of the battery manufacturing data and analyzing its cause illustrated in FIG. 1 is a method according to one embodiment, and the operations of the method of detecting the abnormal point of the battery manufacturing data and analyzing its cause according to the present disclosure are not limited to the embodiment illustrated in FIG. 1, and operations may be added, changed, or deleted as necessary. For convenience of description, it is assumed that the method of detecting the abnormal point of the battery manufacturing data and analyzing its cause is performed by the abnormal point detection and cause analysis system 1000.

Hereinafter, each operation of the method of detecting the abnormal point of the battery manufacturing data and analyzing its cause according to the embodiments of the present disclosure will be described with reference to FIGS. 1 to 6B.

Operation S110 is an operation of collecting training data.

The abnormal point detection and cause analysis system 1000 collects training data including material information, design information, process information, and information on whether an abnormal point has occurred, of a battery (model) to be analyzed. For example, the abnormal point detection and cause analysis system 1000 may access a database of an external system (e.g., a battery design and simulation management system and/or a manufacturing execution system (MES)), in which design information, material information, process information, and evaluation information are linked and stored based on a design identifier (design ID), to collect the training data. Therefore, the training data includes material information, design information, process information, and evaluation information of a battery to be analyzed, and the respective pieces of information are linked to each other based on the design identifier. The training data may comprise simulated data, real-world data or a combination of simulated data and real-world data. Real-world data may be provided by a MES. A MES may be configured to manage (e.g. control) and monitor the execution of real-time physical processes involved in production.

Operation S120 is an operation of selecting latent factors that relate to an abnormal point.

The abnormal point detection and cause analysis system 1000 selects latent factors that cause the abnormal point from among material elements, design elements, and process elements using a machine learning technique on the basis of the training data collected in

operation S110 and a user input.

Examples of the machine learning technique that can be utilized to select the latent factors include principal component analysis (PCA), a latent space, a decision tree ensemble, etc. In this specification, an example of selecting latent factors using a decision tree ensemble is described.

In the present disclosure, latent factors that cause an abnormal point of battery manufacturing data are divided into fixed factors and variable factors.

Fixed factors are factors selected based on expert knowledge in the field of battery technology and are fixedly reflected in an abnormal point cause analysis model which is described herein. For example, the fixed factors are latent factors selected by a user on the basis of natural science, engineering knowledge, or experience related to battery design and manufacturing, and items known to have a high influence on battery process quality and performance may be selected. Fixed factors may be factors predefined (e.g. predefined by the user).

Variable factors are factors excluding the fixed factors selected by the user from among the material elements, the design elements, and the process elements, and are latent factors that are automatically selected by the abnormal point detection and cause analysis system 1000 on the basis of the training data. Variable factors may be factors determined (e.g. selected) by the abnormal point detection and cause analysis system 1000.

The variable factors may be selected regardless of process items (a constant variation factor is applied to various process items), or separate decision trees (decision trees for data on whether an abnormal point has occurred in a specific process item or a specific group of process items) and the variable factors may be selected according to the process item or the group of process items.

The abnormal point detection and cause analysis system 1000 receives the fixed factors from the user. That is, the user selects the fixed factors from among the material elements, the design elements, and the process elements of the battery to be analyzed, and a result of the selection of the fixed factors is input into the abnormal point detection and cause analysis system 1000.

The abnormal point detection and cause analysis system 1000 uses the training data that has been previously collected to select the variable factors from among the remaining factors (elements) excluding the fixed factors input by the user from among the material elements, the design elements, and the process elements of the battery to be analyzed. Specifically, the abnormal point detection and cause analysis system 1000 repeats a process for randomly sampling a predetermined number of items from among the material elements, the design elements, and the process elements of the battery to be analyzed and generating a plurality of decision trees for the sampled items a predetermined number of times, selects some decision trees from among the plurality of generated decision trees on the basis of an average Gini index of the plurality of decision trees, and selects the variable factors on the basis of a frequency of appearance in the some decision trees.

The abnormal point detection and cause analysis system 1000 selects the fixed factors that are selected by the user and the variable factors that are selected using the decision trees, as described herein, as the latent factors to be used in a process for generating an abnormal point cause analysis model.

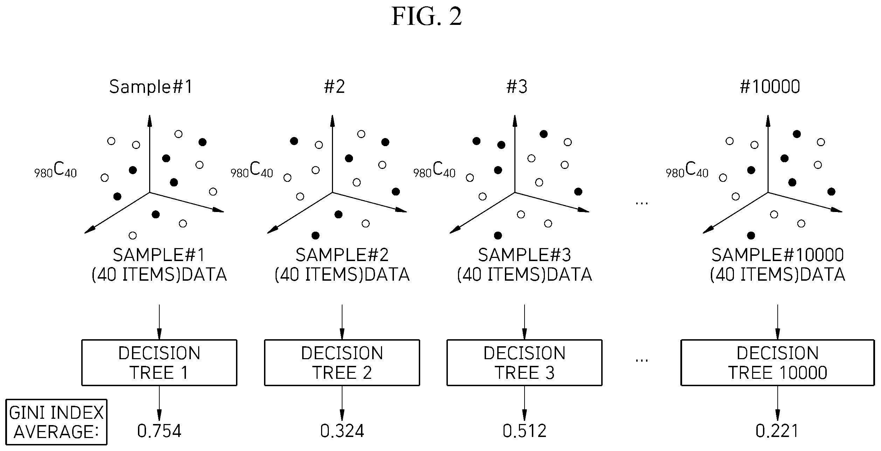

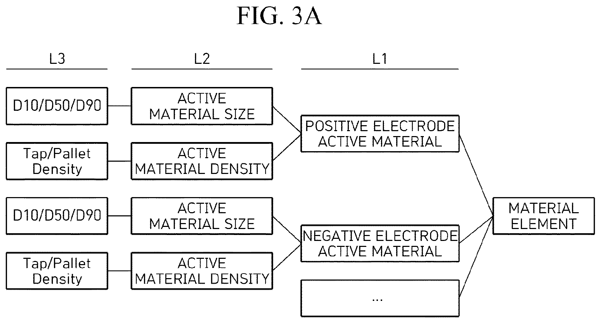

Hereinafter, the process for selecting the latent factors performed by the abnormal point detection and cause analysis system 1000 will be described in detail with reference to FIGS. 2 and 3A to 3C.

FIG. 2 is a diagram for describing a process for selecting latent factors that cause an abnormal point using decision trees and a Gini index, and FIGS. 3A to 3C are classification diagrams of latent factors related to materials, designs, and processes.

Among latent factors, material elements, design elements, and process elements may be classified step by step as shown in FIGS. 3A to 3C. For example, as shown in FIG. 3A, the material elements may be divided into material elements for a positive electrode active material and material elements for a negative electrode active material at a first level L1. The material elements for a positive electrode active material include an active material size and an active material density as shown at a second level L2. The material elements for a negative electrode active material include an active material size and an active material density as shown at a second level L2. In addition, as shown at a third level L3, any one of D10, D50, and D90 may be determined as the active material size. In addition, as shown at a third level L3, the active material density may be a tap/pallet density.

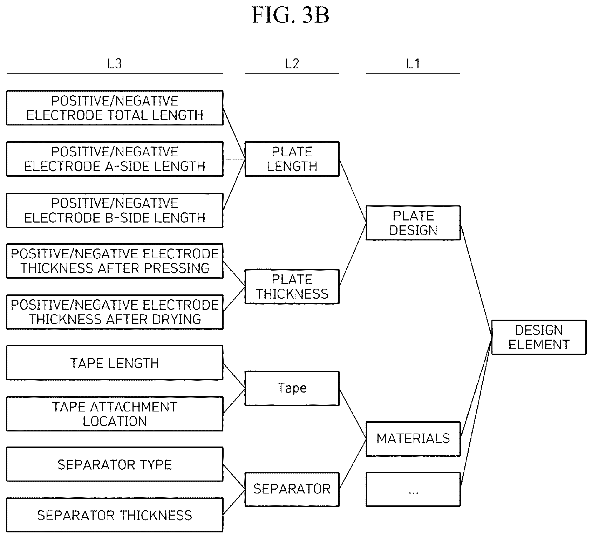

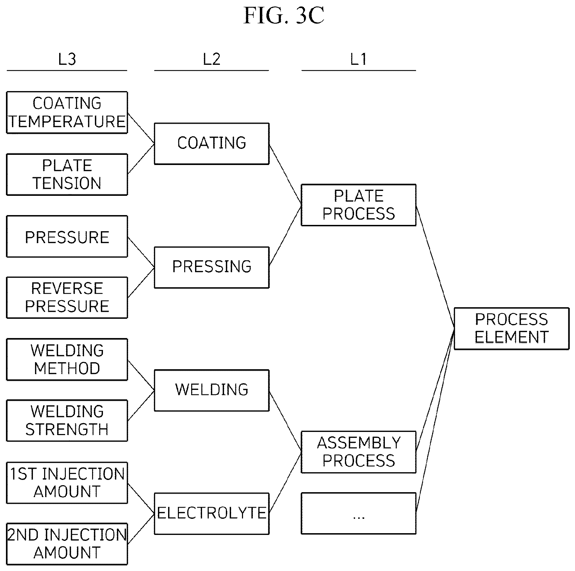

The design elements of FIG. 3B and the process elements of FIG. 3C, like the material elements, may be classified from a first level, which is an upper item, to a third level, which is a lower item, to form a latent factor pool. At each level, the classifications may become more specific (e.g. may relate to more specific features).

In the examples of FIGS. 3A to 3C, latent factors 1), 2), and 3) herein may be added. Like other latent factors, the latent factors listed in 1), 2), and 3) herein may also be selected as the fixed factors or the variable factors. For example:

> 1) (L0) Material - (L1) electrolyte - (L2) additive - (L3) fluoroethylene carbonate (FEC) fraction
> 2) (L0) Design - (L1) materials - (L2) separator - (L3) ceramic coating thickness
> 3) (L0) Process - (L1) production line

FIGS. 3A to 3C provide examples of potential latent factors at various classification levels. It will be appreciated that these are examples, and the specific latent factors used may be adapted depending on the scenario in question.

The abnormal point detection and cause analysis system 1000 may generate an artificial neural network structure of an abnormal point cause analysis model on the basis of the latent factor pool in which all the latent factors of the material elements, the design elements, and the process elements are hierarchically classified.

For example, the latent factor pool (a group of candidate key factors of the cause system) may be a data structure in which all latent factors (e.g., 1,000 latent factors) related to materials, designs, and processes that may affect manufacturing process data of a battery to be analyzed are classified into first to third levels. The latent factors of the lower levels (e.g. L3, L2, L1...) may be subsets (e.g. sub-classifications) of the latent factors at higher levels. The abnormal point detection and cause analysis system 1000 may regard the respective latent factors as independent latent factors, and select latent factors (e.g., 60 latent factors) to form an abnormal point cause analysis model through a user input and decision trees.

The abnormal point detection and cause analysis system 1000 selects fixed factors (e.g., 20 fixed factors) on the basis of battery domain knowledge and then selects variable factors (e.g., 40 variable factors) from among the remaining factors using the decision trees.

First, the abnormal point detection and cause analysis system 1000 selects fixed factors from the latent factor pool on the basis of the battery domain knowledge. For example, the abnormal point detection and cause analysis system 1000 may select 20 latent factors from among 1,000 latent factors on the basis of the user input.

The fixed factors may be selected based on the battery domain knowledge.

For example, the fixed factors may be determined by the user directly selecting items known to have a high influence on battery process quality and performance by utilizing natural science/engineering knowledge or experience related to battery design and manufacturing.

As another example, the abnormal point detection and cause analysis system 1000 may access a machine learning model (e.g. a natural language model, such as a large language model (LLM)) instead of the user input and derive the fixed factors using various types of inputs (e.g. prompts) that are prepared. The abnormal point detection and cause analysis system 1000 may select a predetermined number of fixed factors in order of factors with a high occurrence frequency, from among the factors derived by inputting a plurality of inputs (e.g. prompts) for deriving fixed factors into a plurality of machine learning models (e.g. LLMs).

In addition, the abnormal point detection and cause analysis system 1000 automatically selects a predetermined number of variable factors from among the remaining items of the latent factor pool excluding the fixed factors using machine learning.

For example, when there are 1,000 factors included in the items of the latent factor pool and 20 fixed factors are selected from among the 1,000 factors, the abnormal point detection and cause analysis system 1000 may automatically select 40 variable factors from among the remaining 980 items using machine learning. The abnormal point detection and cause analysis system 1000 may select 40 items from among the 980 items excluding the fixed factors from the latent factor pool through random sampling and generate a decision tree composed of the 40 items that are randomly sampled with respect to the occurrence of the abnormal point. A maximum depth of the decision tree may be limited. As a specific implementation example, the decision tree may be generated using the "DecisionTreeClassifier" class in the "Scikit_learn" package in Python.

The abnormal point detection and cause analysis system 1000 may generate a plurality of decision trees (e.g., 10,000 decision trees) by repeating random sampling and a process for generating a decision tree. For instance, each decision tree may be built by selecting a random sample of parameters (e.g. latent factors) and building a decision tree based on the latent factors. The abnormal point detection and cause analysis system 1000 may digitize a classification result of each decision tree, and select a decision tree to be applied to the selection of latent factors from among the plurality of decision trees on the basis of the digitized classification result. For example, the abnormal point detection and cause analysis system 1000 may calculate an average Gini index of all nodes of the decision tree and select decision trees on the basis of the average Gini index (see FIG. 2).

The Gini index (otherwise known as the Gini impurity, or the Gini's diversity index) measures the probability of incorrectly labelling a randomly chosen element of a set if it were labeled randomly and independently according to the distribution of labels in the set. It reaches its minimum (zero) when all cases in the node fall into a single target category. The Gini index $I_G(p)$ may be calculated as:

$$I_G(p) = 1 - \sum_{i=1}^{J} p_i^2$$

where $p_i$ is the probability of choosing an item with label $i$ (out of $J$ potential labels/classes). $p_i$ may be calculated by determining the number (e.g. the proportion) of class $i$ instances (e.g. at a given node).

For example, the abnormal point detection and cause analysis system 1000 may select some decision trees (e.g., 2,000 decision trees) in decreasing order of the average Gini index. In addition, the abnormal point detection and cause analysis system 1000 may select a predetermined number (e.g., 40) of items in order of highest occurrence frequency from among the some selected decision trees as variation factors to be reflected in the abnormal point cause analysis model.

Operation S130 is an operation of generating an abnormal point cause analysis model. The abnormal point detection and cause analysis system 1000 forms an artificial neural network structure on the basis of the latent factors selected in operation S120 and trains the artificial neural network structure on the basis of the training data collected in operation S110 to generate the abnormal point cause analysis model.

As described herein, the artificial neural network structure of the abnormal point cause analysis model is formed based on the selected latent factors in operation S120.

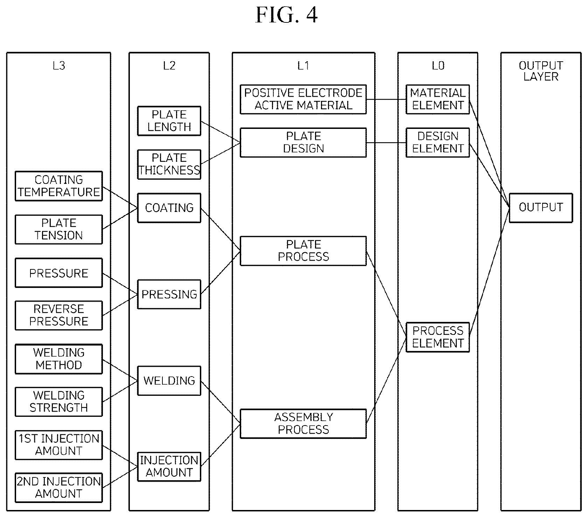

FIG. 4 shows an example of an abnormal point cause analysis model with an artificial neural network structure in which nodes are formed according to a result of selection of latent factors.

A $0^{th}$ layer L0 of the artificial neural network structure shown in FIG. 4 is a layer immediately before an output layer, where fixed nodes such as material elements, design elements, and process elements are arranged. Materials, designs, and processes have a temporal order in the generation of their data, but the artificial neural network structure does not reflect this order and is configured as a single layer L0 by parallelizing the materials, designs, and processes. In addition, selected latent factors are placed in nodes from a first layer L1 to a third layer L3. That is, the abnormal point detection and cause analysis system 1000 places a node of the corresponding latent factor in the layer that matches the classification level of the selected latent factor from the first layer L1 to the third layer L3 while the $0^{th}$ layer L0 that distinguishes between the materials, the designs, and the processes is fixed. However, when a latent factor of a lower classification is selected, the corresponding node and the node of the $0^{th}$ layer L0 should be connected, and thus the abnormal point detection and cause analysis system 1000 places a node of an upper latent factor in the artificial neural network structure regardless of whether the node of the upper latent factor is selected for the corresponding latent factor. For example, when a coating temperature item corresponding to the third classification L3 of the process elements is selected as the latent factor, the abnormal point detection and cause analysis system 1000 generates a coating L2 node and a plate process L1 node in the artificial neural network structure regardless of whether the coating L2 and plate process L1 items, which are upper latent factors of the coating temperature item, are selected as the latent factors in operation S120. Further, when a plate length corresponding to the second classification L2 of the design elements is selected as the latent factor, the abnormal point detection and cause analysis system 1000 generates a plate design L1 node, which is an upper latent factor of the plate length item, regardless of whether the latent factor is selected, and places the generated plate design L1 node in the artificial neural network structure.

For reference, in the example of FIG. 4, a positive/negative electrode length L3, which is a lower classification of the plate length L2, is not selected as the latent factor, and thus is not placed in the artificial neural network structure.

Further, a positive electrode active material item, which is the first classification L1 of the material element, is selected as the latent factor, but the subordinate latent factor of the positive electrode active material item is not selected, and thus in the example of FIG. 4, a node is generated only for the positive electrode active material item and a node of its subordinate latent factor is not generated.

Accordingly, the formation of the abnormal point cause analysis model may comprise placing selected latent factors at their respective positions (e.g. level) within a hierarchical structure. For each selected latent factor, any higher level latent factors (e.g. any higher level classifications to which the lower latent factor belong) that are required to connect the selected latent factor to the output layer are also selected to ensure connection between the lower level latent factors and the output layer.

As described herein, when the artificial neural network structure is formed, the abnormal point detection and cause analysis system 1000 trains the artificial neural network structure on the basis of the training data collected in operation S110 to generate an abnormal point cause analysis model.

The abnormal point detection and cause analysis system 1000 extracts data corresponding to the latent factor placed in a terminal node (e.g. an input node) of the artificial neural network structure (e.g., a length of the L2 electrode in FIG. 4 is also a terminal node) and information on whether an abnormal point has occurred (e.g., 0 is normal, and 1 is occurrence of an abnormal point) from the previously collected training data (e.g., the material information, the design information, the process information, and the information on whether the abnormal point has occurred). For instance, the training data may include a number of training examples, wherein each training example includes a value for each parameter (e.g. for each latent factor) and a label (e.g. 0 or 1) indicating whether the training example is abnormal. The abnormal point detection and cause analysis system 1000 inputs the data of the latent factors from among the extracted data into the terminal node of the artificial neural network structure, uses the information on whether the abnormal point has occurred (e.g., 0 is normal, and 1 is occurrence of an abnormal point) as a label, and trains the artificial neural network structure, for example, by updating weights of edges connecting nodes of the artificial neural network through a backpropagation algorithm to generate the abnormal point cause analysis model.

For instance, based on the labelled training data, the artificial neural network structure may be trained to identify abnormalities in sets of latent factors. For a given example comprising values for each latent factor, the values may be input into the artificial neural network which may generate an output that represents a prediction of whether the example is an abnormal point. The value may be a hard decision value (e.g. a 0 or a 1) or a soft decision value (e.g. a value indicative of a probability of abnormality, such as a value ranging between 0 and 1). A loss value may be determined base don a loss function and based on the label and the output. For instance, the error of the prediction may be determined (e.g. the difference between the output and the label). The loss may then be used to update the artificial neural network (e.g. through backpropagation, such as through gradient descent back propagation). For instance, the artificial neural network may be trained using an objective function that aims to minimize the loss (e.g. minimize the error).

Operation S140 is an operation of collecting and monitoring manufacturing process data.

The abnormal point detection and cause analysis system 1000 accesses an external system (e.g., a battery design and simulation management system and/or a manufacturing execution system (MES)) to collect manufacturing process data of the battery to be analyzed, and monitors whether an abnormal point has occurred in the manufacturing process data using statistical techniques such as a scatter plot, a kernel density estimation (KDE) technique, etc.

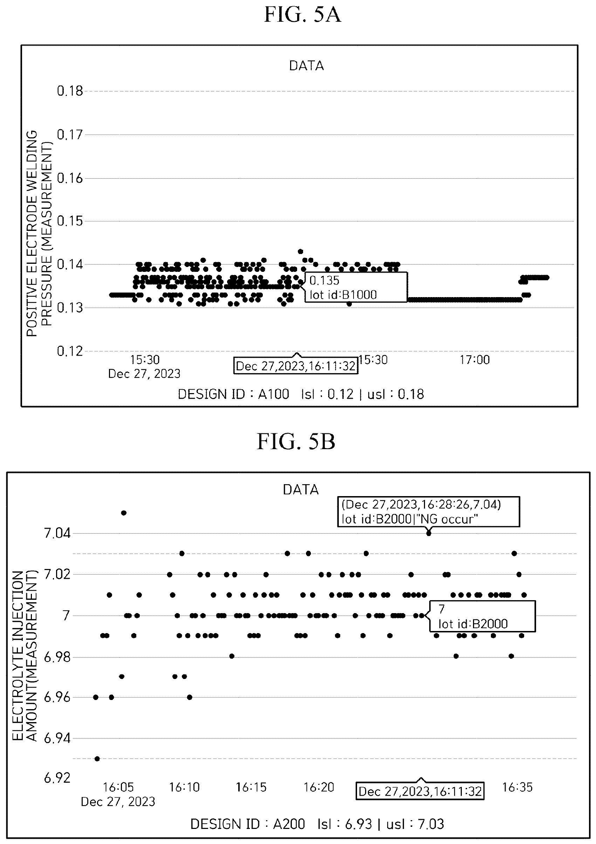

FIGS. 5A and 5B show examples of scatter plots showing time series data for each process item. A process item may be an item (e.g. an individual unit, component or material) that is undergoing a process (e.g. worked on, modified, used, formed or produced) during the manufacturing process.

The abnormal point detection and cause analysis system 1000 may display data (manufacturing process data) for each process item generated in the battery manufacturing process according to each design (distinguished by a design identifier (design ID)) as a time series scatter plot. As shown in FIGS. 5A and 5B, the user may check the occurrence time and occurrence lot information of each piece of data in the time series scatter plots. Further, an upper specification limit (USL) and a lower specification limit (LSL) of the corresponding process item (manufacturing process data) are displayed in the time series scatter plots. FIG. 5A shows a time series scatter plot for negative electrode welding pressure among process items, and it can be seen that no out-of-spec negative electrode welding pressure data has occurred in a corresponding time interval. FIG. 5B shows a time series scatter plot for electrolyte injection amount among process items and shows a case where out-of-spec electrolyte injection amounts have occurred that exceeded the USL. Data corresponding to one of the spec-outs is highlighted.

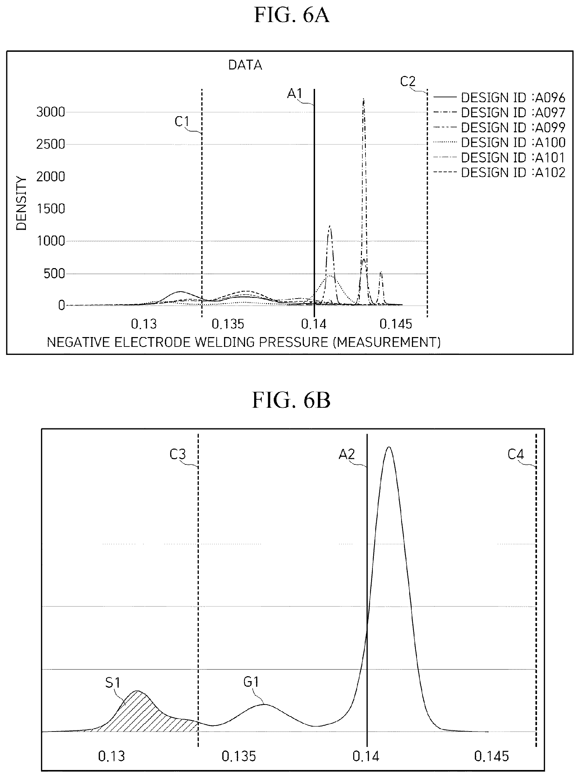

FIGS. 6A and 6B show examples of kernel density estimation plots showing a data distribution of process items.

In the present disclosure, a kernel density estimation plot is used to determine trend deviation of manufacturing process data. The abnormal point detection and cause analysis system 1000 generates a kernel density estimation plot representing data distribution by design (distinguished by a design identifier) in order to determine the trend deviation of the manufacturing process data, sets trend deviation reference lines C1 to C4, and determines that an abnormal point has occurred when an area S1 of a graph G1 that deviates from the trend deviation reference line is greater than or equal to a set threshold value. For reference, in FIGS. 6A and 6B, model averages (an average value of corresponding process items of a battery to be analyzed) are indicated by reference symbols A1 and A2.

In the present disclosure, the abnormal point detection and cause analysis system 1000 may use a Gaussian kernel to generate a kernel density estimation plot. Further, the abnormal point detection and cause analysis system 1000 may calculate each kernel density bandwidth to appropriately represent a data distribution for each design to generate a graph, and a calculation formula for a kernel density bandwidth h is as shown in Equation 1.

[Equation 1]

$$h = \left(\frac{4\sigma^5}{3n}\right)^{0.2}$$

In Equation 1, h denotes the kernel density bandwidth, n denotes the number of pieces of manufacturing process data, and $\sigma$ denotes a standard deviation of data.

Further, the abnormal point detection and cause analysis system 1000 standardizes each kernel density estimation plot into a graph with an area of 1 by dividing each kernel density estimation plot by the number of pieces of data to prevent bias caused by differences in the number of pieces of data per design.

The trend deviation reference line may be set by utilizing an average and standard deviation of all data generated from the process items of the corresponding model (there may be a plurality of designs for one model). For example, when the average is calculated, a simple weighted average may be used where the weights are set equally for each design. Specifically, the abnormal point detection and cause analysis system 1000 may first calculate an arithmetic mean for each design with different numbers of data and then calculate an average of the calculated arithmetic means to obtain a final average. Further, the abnormal point detection and cause analysis system 1000 may use the standard deviation of all the data as the standard deviation $\sigma$ applied to the trend deviation reference line regardless of design information.

As a result of field application, it was confirmed that when the trend deviation reference lines C1 to C4 were set to $\pm 1.5\,\sigma$ point from the model average, the trend deviation items were generated at an appropriate level. Therefore, the abnormal point detection and cause analysis system 1000 may set the $\pm 1.5\,\sigma$ point from the model average as the trend deviation reference line.

In addition, the abnormal point detection and cause analysis system 1000 may calculate an area where the kernel density estimation plot deviates from the trend deviation reference line, and when the calculated area is greater than or equal to a threshold value, may determine that the trend deviation has occurred. For example, the abnormal point detection and cause analysis system 1000 determines that the trend deviation has occurred when the area of the graph (kernel density estimation plot) that ultimately exceeds the trend deviation reference line is 0.3 or more, and that the data occurrence pattern of the design is significantly different from the data occurrence patterns of other designs.

Operation S150 is an operation of determining whether an abnormal point has occurred. The abnormal point detection and cause analysis system 1000 performs operation S160 when the abnormal point (spec-out or out-of-specification) occurs in the manufacturing process data and otherwise terminates the process or continuously performs operation S140 until the abnormal point is detected in the manufacturing process data.

Operation S160 is an operation of selecting key factors that cause an abnormal point. The abnormal point detection and cause analysis system 1000 selects key factors affecting occurrence of the abnormal point from among the selected latent factors using the abnormal point cause analysis model generated in operation S130 on the basis of the material information, design information, and process information of the battery to be analyzed when the abnormal point has occurred in the manufacturing process data.

Specifically, the abnormal point detection and cause analysis system 1000 inputs the data of the latent factor corresponding to the model or design identifier in which the abnormal point has occurred into a terminal node (input unit) of the abnormal point cause analysis model, inputs the information on whether the abnormal point has occurred (e.g., occurrence of an abnormal point=1) into an output node, and calculates a change in weight of each edge that changes according to a backpropagation algorithm. For instance, the weights of the artificial neural network may be updated based on the data from the abnormal point and a label indicating that the abnormal point has occurred (e.g. a value of 1). For instance, the abnormal point detection and cause analysis system 1000 may input the data of the latent factors corresponding to the model or design identifier in which the abnormal point has occurred into terminal nodes (e.g. input notes) of the artificial neural network to generate an output (e.g. a prediction of whether the data relates to an abnormal point). A loss may be determined (the output of a loss function), such as an error. For instance, an error may be determined based on a difference between the output and the label (e.g. a value of 1 indicating the occurrence of an abnormal point). Backpropagation may be used to update the weights of the artificial neural network based on the loss (e.g. the error). The input nodes associated with the largest changes in weights may be considered to relate to latent factors that are key factors. For instance, the abnormal point detection and cause analysis system 1000 may determine that the latent factor corresponding to a front node (input node side) of an edge with a large weight change value has a high influence on the occurrence of the abnormal point. Therefore, the abnormal point detection and cause analysis system 1000 selects the key factors affecting occurrence of the abnormal point by selecting latent factors corresponding to the front node in order from larger to smaller changes in weights of the edges.

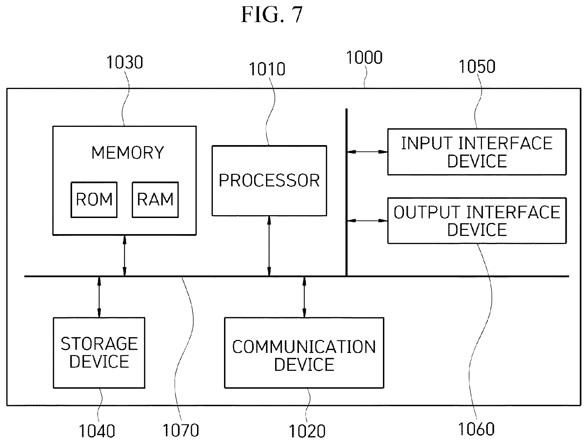

For reference, when the data input for selecting the key factors is relatively small compared to the data used for training the artificial neural network (e.g., experimental data), an influence of the latter data on the weights of the neural network is small. Therefore, in order to produce a significant change in weight of size, it is necessary to input the same data repeatedly. For example, in order to calculate the weight influence of 10,001$^{st}$ experimental data on the neural network trained through 10,000 pieces of experimental data (design of experiments (DOE)), the 10,001$^{st}$ data is repeatedly input into the neural network 1,000 times or more and then the weight change is calculated. The method of detecting the abnormal point of the battery manufacturing data and analyzing its cause has been described herein with reference to the flowchart illustrated in FIG. 1, for example. For simplicity, the method has been depicted and described as a series of blocks, but the present disclosure is not limited to the order of the blocks, and some blocks may occur in a different order or simultaneously with other blocks than depicted and described herein, and various other branches, flow paths, and block orders that achieve the same or similar results may be implemented. In addition, not all of the blocks depicted may be required to implement the method described herein. Meanwhile, in the description referring to FIGS. 1 to 6B, each operation may be further divided into additional operations or the operations may be combined into fewer operations, depending on the implementation example of the present disclosure. In addition, some operations may be omitted as necessary, and the order between the operations may be changed. In addition, the content of FIGS. 1 to 6B may be applied to the content of FIG. 7.

FIG. 7 is a block diagram illustrating a configuration of a system for detecting an abnormal point of battery manufacturing data and analyzing its cause according to embodiments of the present disclosure. A system 1000 for detecting the abnormal point of the battery manufacturing data and analyzing its cause (hereinafter referred to as an "abnormal point detection and cause analysis system") may be implemented in the form of a computer system illustrated in FIG. 7.

Referring to FIG. 7, the abnormal point detection and cause analysis system 1000 may include at least one of a processor 1010, a memory 1030, an input interface device 1050, an output interface device 1060, and a storage device 1040 that communicate via a bus 1070. The abnormal point detection and cause analysis system 1000 may further include a communication device 1020 coupled to a network. The processor 1010 may be a central processing unit (CPU) or a semiconductor device that executes computer-readable instructions stored in the memory 1030 or storage device 1040. The memory 1030 and the storage device 1040 may include various types of volatile or nonvolatile storage media. For example, the memory 1030 may include a read-only memory (ROM) and a random access memory (RAM). The memory 1030 may be a non-transitory memory (e.g., at least one non-transitory computer-readable medium). In the embodiments of the present disclosure, the memory 1030 may be located inside or outside the processor 1010, and the memory 1030 may be connected to the processor 1010 through various methods that are already known. The memory 1030 may be one of various types of volatile or non-volatile storage media, including, for example, a ROM or a RAM.

Therefore, the embodiments of the present disclosure may be implemented as a computer-implemented method or as a non-transitory computer-readable medium in which computer-executable instructions are stored. In one embodiment, when the embodiment is performed by the processor 1010, the computer-readable instructions may perform the method according to at least one aspect of the present disclosure.

The communication device 1020 may transmit or receive wired or wireless signals.

Further, the method of detecting the abnormal point of the battery manufacturing data and analyzing its cause according to the embodiments of the present disclosure may be implemented in the form of program commands that can be performed through various computer devices and recorded on a computer-readable medium.

The computer-readable medium may include program commands, data files, data structures, etc., alone or in combination. The program commands recorded on the computer-readable medium may be specially designed and configured for the embodiments of the present disclosure or may be known and available to those skilled in the art of computer software. A computer-readable recording medium may include a hardware device configured to store and execute program instructions. For example, the computer-readable recording medium may be a magnetic medium such as a hard disk, a floppy disk, and magnetic tape, an optical medium such as a compact disc read-only memory (CD-ROM) or a digital video disc (DVD), a magneto-optical medium such as a floptical disk, a ROM, a RAM, a flash memory, etc. The program instructions may include machine language code, such as that produced by a compiler, as well as high-level language code that can be executed by a computer through an interpreter or the like.

The processor 1010 is configured to, by executing the computer-readable instructions stored in the memory 1030 or storage device 1040, collect training data including material information, design information, process information, and information on whether an abnormal point has occurred, of a battery to be analyzed, select latent factors that cause the abnormal point from among material elements, design elements, and process elements on the basis of the training data, form an artificial neural network structure on the basis of the selected latent factors, and train the artificial neural network structure on the basis of the training data to generate an abnormal point cause analysis model.

Further, the processor 1010 may be configured to, in the process for selecting the latent factors, select variable factors from among the remaining elements excluding fixed factors from among the material elements, the design elements, and the process elements using the training data, and select the fixed factors and the variable factors as the latent factors when a user of the abnormal point detection and cause analysis system 1000 selects the fixed factors from among the material elements, the design elements, and the process elements.

Further, the processor 1010 may be configured to, in the process for selecting the variable factors, repeat a process for randomly sampling a predetermined number of items from among the material elements, the design elements, and the process elements and generating a plurality of decision trees for the sampled items a predetermined number of times, select some decision trees from among the plurality of generated decision trees on the basis of an average Gini index of the plurality of decision trees, and select the variable factors on the basis of the some decision trees.

Further, the processor 1010 may be configured to, in the process for selecting the variable factors, select the variable factors on the basis of a frequency of appearance in the some decision trees.

Further, the processor 1010 may be configured to collect manufacturing process data of the battery to be analyzed, determine whether the abnormal point has occurred in the manufacturing process data using a statistical technique, and select key factors affecting occurrence of the abnormal point from among the selected latent factors using the abnormal point cause analysis model on the basis of the material information, the design information, and the process information of the battery to be analyzed when the abnormal point has occurred in the manufacturing process data.

The statistical technique may include scatter plot analysis and/or kernel density estimation.

According to the embodiments of the present disclosure, by utilizing material information, design information, and process information that are linked through a battery design and simulation management system, it is possible to minimize the inconvenience of directly extracting and analyzing data from various information sources in searching for an abnormal point and analyzing its cause.

Further, according to the embodiments of the present disclosure, it is possible to provide information on key causes that contributed to the occurrence of an abnormal point to a model developer through advanced abnormal point detection and cause analysis by integrating domain knowledge, statistical techniques, and machine learning techniques.

Effects of the present disclosure are not limited to those described herein, and other effects not specifically mentioned herein will be clearly understood by those skilled in the art from the description of the present disclosure herein.

Although the present disclosure has been described herein with respect to embodiments thereof, the present disclosure is not limited thereto. Various modifications and variations can be made thereto by those skilled in the art within the scope of the invention as defined by the appended claims and their equivalents.

**Claims**

1. A method of detecting an abnormal point of battery manufacturing data and analyzing its cause, the method comprising:

   collecting (S110), by an abnormal point detection and cause analysis system for detecting the abnormal point of battery manufacturing data and analyzing its cause, training data including material information, design information, process information, and information on whether an abnormal point has occurred, of a battery to be analyzed;
   selecting (S120), by the abnormal point detection and cause analysis system, latent factors that cause the abnormal point from among material elements, design elements, and process elements on the basis of the training data;
   forming, by the abnormal point detection and cause analysis system, an artificial neural network structure on the basis of the selected latent factors;
   training the artificial neural network structure on the basis of the training data; and
   generating (S130) an abnormal point cause analysis model.

2. The method as claimed in claim 1, wherein the selecting (S120) of the latent factors comprises:

   selecting, by a user of the abnormal point detection and cause analysis system, fixed factors from among the material elements, the design elements, and the process elements;
selecting, by the abnormal point detection and cause analysis system, variable factors from among remaining elements excluding the fixed factors from among the material elements, the design elements, and the process elements using the training data; and
selecting, by the abnormal point detection and cause analysis system, the fixed factors and the variable factors as the latent factors.

3. The method as claimed in claim 2, wherein the selecting of the variable factors comprises:

repeating, by the abnormal point detection and cause analysis system, a process for randomly sampling a predetermined number of items from among the material elements, the design elements, and the process elements and generating a plurality of decision trees for the sampled items a predetermined number of times;
selecting some decision trees from among the plurality of generated decision trees on the basis of an average Gini index of the plurality of decision trees; and
selecting the variable factors on the basis of the some decision trees.

4. The method as claimed in claim 3, wherein the selecting of the variable factors comprises selecting the variable factors on the basis of a frequency of appearance in the some decision trees.

5. The method as claimed in any preceding claim, further comprising:

collecting (S140), by the abnormal point detection and cause analysis system, manufacturing process data of the battery to be analyzed and determining whether the abnormal point has occurred in the manufacturing process data using a statistical technique; and
when it is determined that the abnormal point has occurred in the manufacturing process data, selecting (S160), by the abnormal point detection and cause analysis system, key factors affecting occurrence of the abnormal point from among the selected latent factors using the abnormal point cause analysis model on the basis of the material information, the design information, and the process information of the battery to be analyzed.

6. The method as claimed in claim 5, wherein the statistical technique comprises kernel density estimation.

7. An abnormal point detection and cause analysis system for detecting an abnormal point of battery manufacturing data and analyzing its cause, comprising:

a non-transitory memory configured to store computer-readable instructions; and
at least one processor configured to execute the computer-readable instructions,
wherein the at least one processor is configured to, by executing the computer-readable instructions, perform a method comprising:

collecting (S110) training data including material information, design information, process information, and information on whether an abnormal point has occurred, of a battery to be analyzed;
selecting (S120) latent factors that cause the abnormal point from among material elements, design elements, and process elements on the basis of the training data;
forming an artificial neural network structure on the basis of the selected latent factors;
training the artificial neural network structure on the basis of the training data; and
generating (S130) an abnormal point cause analysis model.

8. The system as claimed in claim 7, wherein the selecting (S120) the latent factors comprises selecting variable factors from among remaining elements excluding fixed factors from among the material elements, the design elements, and the process elements using the training data and selecting the fixed factors and the variable factors as the latent factors when a user of the abnormal point detection and cause analysis system selects the fixed factors from among the material elements, the design elements, and the process elements.

9. The system as claimed in claim 8, wherein the method further comprises, in the process for selecting the variable factors:

repeating, by the abnormal point detection and cause analysis system, a process for randomly sampling a predetermined number of items from among the material elements, the design elements, and the process elements and generating a plurality of decision trees for the sampled items a predetermined number of times;
selecting some decision trees from among the plurality of generated decision trees on the basis of an average Gini index of the plurality of decision trees; and
selecting the variable factors on the basis of the some decision trees.

**10.** The system as claimed in claim 9, wherein the method further comprises, in the process for selecting the variable factors, selecting the variable factors on the basis of a frequency of appearance in the some decision trees.

**11.** The system as claimed in any of claims 7-10, wherein the method further comprises:

collecting (S140) manufacturing process data of the battery to be analyzed and determine whether the abnormal point has occurred in the manufacturing process data using a statistical technique; and
selecting (S160) key factors affecting occurrence of the abnormal point from among the selected latent factors using the abnormal point cause analysis model on the basis of the material information, the design information, and the process information of the battery to be analyzed when it is determined that the abnormal point has occurred in the manufacturing process data.

**12.** The system as claimed in claim 11, wherein the statistical technique comprises kernel density estimation.

# FIG. 1

```
              ┌─────────┐
              │  START  │
              └─────────┘
                   │
                   ▼
        ┌──────────────────────┐   S110
        │ COLLECT TRAINING DATA│
        └──────────────────────┘
                   │
                   ▼
        ┌──────────────────────┐   S120
        │  SELECT LATENT FACTOR │
        └──────────────────────┘
                   │
                   ▼
        ┌──────────────────────┐   S130
        │ GENERATE ABNORMAL POINT│
        │  CAUSE ANALYSIS MODEL │
        └──────────────────────┘
                   │
                   ▼
        ┌──────────────────────┐   S140
        │  COLLECT AND MONITOR  │
        │  MANUFACTURING DATA   │
        └──────────────────────┘
                   │
                   ▼
              ╱──────────╲          S150
            ╱    HAS       ╲   NO
          ╱ ABNORMAL POINT  ╲──────┐
           ╲   OCCURRED?    ╱       │
            ╲──────────────╱        │
                   │ YES            │
                   ▼                │
        ┌──────────────────────┐   S160
        │  SELECT KEY FACTORS   │    │
        └──────────────────────┘    │
                   │                 │
                   ◄─────────────────┘
                   ▼
              ┌─────────┐
              │   END   │
              └─────────┘
```

# FIG. 2

Sample#1      #2      #3      #10000

$_{980}C_{40}$      $_{980}C_{40}$      $_{980}C_{40}$    ...    $_{980}C_{40}$

SAMPLE#1 (40 ITEMS)DATA    SAMPLE#2 (40 ITEMS)DATA    SAMPLE#3 (40 ITEMS)DATA    SAMPLE#10000 (40 ITEMS)DATA

| DECISION TREE 1 | DECISION TREE 2 | DECISION TREE 3 | ... | DECISION TREE 10000 |

GINI INDEX AVERAGE:

0.754      0.324      0.512      0.221

EP 4 679 213 A1

# FIG. 3A

| L3 | L2 | L1 |
|---|---|---|

## FIG. 3B

| L3 | L2 | L1 |
|---|---|---|

POSITIVE/NEGATIVE ELECTRODE TOTAL LENGTH

POSITIVE/NEGATIVE ELECTRODE A-SIDE LENGTH — PLATE LENGTH

POSITIVE/NEGATIVE ELECTRODE B-SIDE LENGTH

POSITIVE/NEGATIVE ELECTRODE THICKNESS AFTER PRESSING

POSITIVE/NEGATIVE ELECTRODE THICKNESS AFTER DRYING — PLATE THICKNESS

PLATE DESIGN

TAPE LENGTH

TAPE ATTACHMENT LOCATION — Tape

DESIGN ELEMENT

SEPARATOR TYPE

SEPARATOR THICKNESS — SEPARATOR

MATERIALS

...

FIG. 3C

FIG. 4

## FIG. 5A

## FIG. 5B

## FIG. 6A

## FIG. 6B

FIG. 7

Europäisches
Patentamt

European
Patent Office

Office européen
des brevets

# EUROPEAN SEARCH REPORT

**Application Number**

EP 25 18 7064

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/314527 A1 (SECOUARD CHRISTOPHE [FR] ET AL) 5 October 2023 (2023-10-05) * the whole document * ----- | 1-12 | INV. G05B23/02 |
| A | LIU KAILONG ET AL: "Feature Analyses and Modeling of Lithium-Ion Battery Manufacturing Based on Random Forest Classification", IEEE/ASME TRANSACTIONS ON MECHATRONICS, IEEE SERVICE CENTER, PISCATAWAY, NJ, US, vol. 26, no. 6, 5 January 2021 (2021-01-05), pages 2944-2955, XP011893628, ISSN: 1083-4435, DOI: 10.1109/TMECH.2020.3049046 [retrieved on 2021-12-13] * the whole document * ----- | 1-12 | |

**TECHNICAL FIELDS SEARCHED (IPC)**

G05B

The present search report has been drawn up for all claims

| Place of search | Date of completion of the search | Examiner |
|---|---|---|
| Munich | 27 November 2025 | Marrone, Fabrizio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 7064

27-11-2025

| Patent document cited in search report | Publication date | Patent family member(s) | | Publication date |
|---|---|---|---|---|
| US 2023314527 A1 | 05-10-2023 | CN | 116893346 A | 17-10-2023 |
| | | EP | 4253973 A1 | 04-10-2023 |
| | | FR | 3134240 A1 | 06-10-2023 |
| | | JP | 2023152886 A | 17-10-2023 |
| | | US | 2023314527 A1 | 05-10-2023 |

EPO FORM P0459